Europäisches Patentamt

European Patent Office

Office européen des brevets

(11) Publication number: **0 037 233**

**B1**

(12) **EUROPEAN PATENT SPECIFICATION**

(45) Date of publication of patent specification: **25.09.85**

(21) Application number: **81301251.5**

(22) Date of filing: **24.03.81**

(51) Int. Cl.⁴: **G 11 C 11/24,** G 11 C 8/00, G 11 C 11/40, G 11 C 5/02

(54) **A semiconductor memory device.**

(30) Priority: **31.03.80 JP 41622/80**

(43) Date of publication of application: **07.10.81 Bulletin 81/40**

(45) Publication of the grant of the patent: **25.09.85 Bulletin 85/39**

(84) Designated Contracting States: **DE FR GB NL**

(56) References cited:
EP-A-0 037 227
US-A-4 110 840

THE SEMICONDUCTOR MEMORY BOOK, 1978, pages 131-138, John Wiley + Sons, New York (USA); J.COE: " Designing with 16K dynamic RAMs"
IEEE INTERNATIONAL SOLID-STATE CIRCUITS CONFERENCE, vol. 23, 15th February 1980, pages 234-235, New York (USA); MANO et al.: " A 256k RAM fabricated with molybdenum - polysilicon technology".

(73) Proprietor: **FUJITSU LIMITED**
**1015, Kamikodanaka Nakahara-ku**
**Kawasaki-shi Kanagawa 211 (JP)**

(72) Inventor: **Nakano, Tomio**
**1-11-2-12-404 Shirahatadai Takatsu-ku**
**Kawasaki-shi Kanagawa 213 (JP)**
Inventor: **Takemae, Yoshihiro**
**20-5-9-301 Utsukushigaoka 1-chome Midori-ku**
**Yokohama-shi Kanagawa 227 (JP)**

(74) Representative: **Rackham, Stephen Neil et al**
**GILL JENNINGS & EVERY 53-64 Chancery Lane**
**London WC2A 1HN (GB)**

(56) References cited:
**IEEE JOURNAL OF SOLID-STATE CIRCUITS,**
**vol. SC-13, no. 5, October 1978, pages 607-610,**
**New York (USA); WADA et al.: "A 150ns,**
**150mW, 64K dynamic MOS RAM".**
**ELECTRONICS, vol. 49, no. 10, 13th May 1976,**
**pages 81-86, New York (USA); KUO et al.: "16K**
**RAM built with proven process may offer high**
**start-up reliability"**

**IEEE INTERNATIONAL SOLID-STATE CIRCUITS CONFERENCE, vol. 21, 16th February 1978, pages 148-149, New York (USA); YOSHIMURA et al.: "A 64Kbit MOS RAM".**
**IEEE INTERNATIONAL SOLID STATE CIRCUITS CONFERENCE, Vol. 23, Feb. 1980, pages 66-67, New York (USA), OHTA et al: "A stocked high capacitor RAM"**

## Description

The present invention relates to a semiconductor memory device, and more particularly to a dynamic type RAM device which has a large memory capacity and low power consumption and which is used, for example, in an electronic computer.

A common MOS dynamic RAM device will be described in more detail subsequently and contrasted with the present invention with reference to the drawings. In the report of the IEEE International Solid-State Circuits Conference Vol. 23, February 1980, pages 66—67, New York (USA), an article by OHTA et al entitled "A Stacked High Capacitor RAM" a dynamic memory structure is disclosed which has the following features:—

a plurality of memory blocks each of which includes a sense amplifier array consistimg of a plurality of sense amplifiers, and a pair of dynamic type memory cell groups, a row decoder for selecting a row line in the memory blocks and a column decoder which is common to the plurality of memory blocks and which selectively connects pairs of input/output terminals of one sense amplifier from each of the memory blocks to pairs of bus lines associated with the memory blocks by controlling the potential of the column lines connected between the column decoder and the memory blocks.

In the device disclosed in The Semiconductor Memory Book, 1978, pages 131—138, John Wiley & Sons, New York (USA),]. COE "Designing with 16K dynamic RAMs", two storage arrays share a common set of column address decoders, and a common I/O bus, only the sense amplifers of one of the storage arrays being active during a cycle.

From IEEE International Solid-State Circuits Conference, Vol. 23, 15th February 1980, pages 234—235, New York (USA), MANO et al "A 256K RAM fabricated with molybdenum-polysilicon technology" it is known to provide a memory device having two memory blocks with a decoder circuit for selectively connecting the data from one of the two blocks to a common output amplifier.

From US—A—4 110 840 a single-block static memory device is known comprising a plurality of pairs of gate transistors for selectively connecting a pair of bit sense-write conductors of a plurality of pairs of bit sense-write conductors to a single pair of bit sense conductors coupled to an input/output amplifier.

According to this invention a semiconductor memory device comprises a number of memory blocks each of which includes a sense amplifier array consisting of a number of sense amplifiers and a pair of dynamic type memory cell groups, a number of row decoders each of which is associated with its corresponding memory block and each of which receives row address signals and gated clock signals for its corresponding memory blocks, the gated clock signals being produced by gating a row address clock signal with block selecting address signals, each of the row decoders selecting a particular row line in the memory blocks in response to the gated clock signal; a column decoder, a pair of data bus lines and an input/output amplifier which are common to all the memory blocks, the column decoder selectively connecting pairs of input/output terminals of one sense amplifier from each of the memory blocks to pairs of bus lines associated with the memory blocks by changing the potential of one of a number of column lines connected between the column decoder and the memory blocks, the pair of data bus lines being connected to the input/output amplifier; row block decoders which selectively enable the sense amplifier array of one of the memory blocks in accordance with the block selecting address signals; gate transistors connected between the pairs of bus lines and the data bus lines; and, block bus line decoders which control the operation of the gate transistors to selectively connect the pairs of bus lines associated with each of the memory blocks to the pair of data bus lines in accordance with the block selecting address signals.

The device in accordance with this invention has the advantage that it has a large memory capacity and a greater proportion of its area is used for forming the memory cells. It also has a low power consumption and the differential input voltage to each of its sense amplifiers does not decrease, even when its memory capacity becomes very large. It also has a high operating speed.

Embodiments of a memory device in accordance with this invention will now be described and contrasted with conventional devices with reference to the accompanying drawings, in which:—

Figure 1 is a circuit diagram of a conventional MOS dynamic type RAM device;

Figure 2 is a plan showing the arrangement of parts of the circuit on a semiconductor chip in another conventional memory device;

Figure 3 is a plan showing the arrangement of parts of the circuit on a semiconductor chip in a memory device in accordance with a first embodiment of the present invention;

Figure 4 is a plan showing the arrangement of parts of the circuit on a semiconductor chip in a memory device in accordance with a second embodiment of the present invention;

Figure 5 is a circuit diagram of another embodiment of a memory device in accordance with the present invention; and,

Figure 6 is a waveform diagram illustrating signals in the embodiment of the memory device shown in Figure 5.

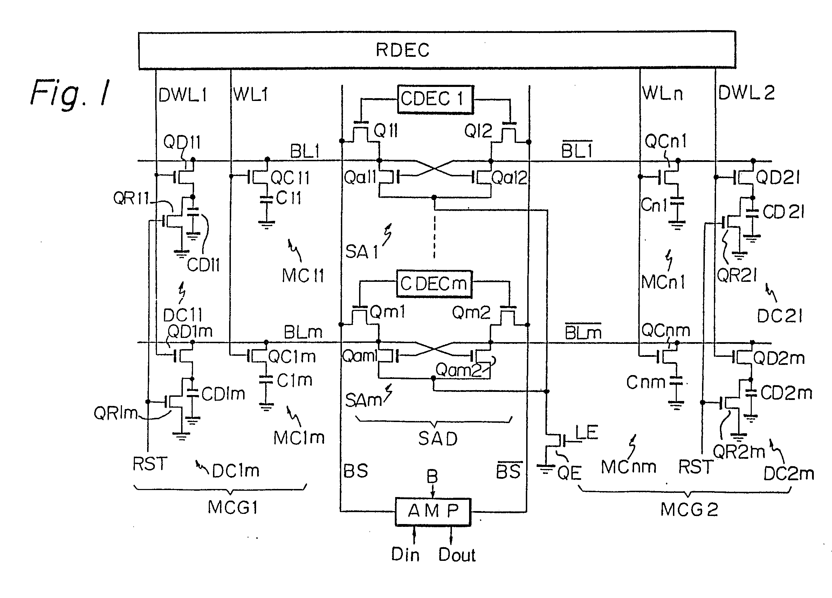

As illustrated in Figure 1, a conventional MOS dynamic type RAM device comprises a row decoder RDEC, sense amplifier and column decoder group SAD which comprises column decoders CDE1 through CDECm and sense amplifiers SA1 through SAm and which is arrayed in the central portion of a memory chip, two memory cell groups MCG1 and MCG2 each of which consists of a plurality of memory cells and dummy cells and which are disposed on both sides of the sense amplifier and column decoder group SAD, and an input/output amplifier AMP. The memory cell group MCG1 comprises the memory cells MCjk (j=1, ..., n/2, k=1, ..., m) disposed in m columns and n/2 rows and m dummy cells DC1k (k=1, ..., m) disposed in a row. The memory cell group MCG2 comprises the memory cells MCjk (j=n/2+1, ..., n; k=1, ..., m) disposed in m columns and n/2 rows and m dummy cells DC2k (k=1, ..., m) disposed in a row. From the row decoder RDEC, n row lines or word lines WL1 through WLn extend in a longitudinal direction of Fig. 1 and each of the row lines WL1 through WLn is connected to m memory cells in a corresponding row of the memory cell groups MCG1 and MCG2. From the row decoder RDEC, two dummy row lines or dummy word lines DWL1 and DWL2 extend parallel to the row lines WL1 through WLn and each of the dummy row lines DWL1 and DWL2 is connected to m dummy cells DC1k or DC2k in a corresponding row of memory cell groups MCG1 and MCG2 respectively. From the sense amplifiers SA1 through SAm, m pairs of bit lines BL1 and $\overline{BL1}$ through BLm and $\overline{BLm}$ extend in a transveres direction in Fig. 1 and each of the bit lines is connected to n/2 memory cells and a dummy cell in a corresponding column. On both sides of the sense amplifier and column decoder group SAD, a pair of bus lines BS and $\overline{BS}$ are arranged and connected to the input/output amplifier AMP. Each of the memory cells MCjk consists of a capacitor Cjk (j=1, ..., n; k=1, ..., m) and a MOS transistor QCjk whose gate electrode is connected to one of the row lines WL1 through WLn and whose source or drain electrode is connected to one of the bit lines BL1 and $\overline{BL1}$ through BLm and $\overline{BLm}$. Each of the dummy cells DC1k and DC2k consists of a capacitor CD1k or CD2k (k=1, ..., m), a MOS transistor QD1k or QD2k whose gate electrode is connected to the dummy row line DWL1 or DWL2 and whose source or drain electrode is connected to one of the bit lines BL1 and $\overline{BL1}$ through BLm and $\overline{BLm}$, and, a MOS transistor QR1k or QR2k which is connected parallely to the capacitor CD1k or CD2k of the dummy cell DC1k or DC2k respectively. The sense amplifiers SA1 through SAm comprise pairs of cross coupled MOS transistors Qa11 and Qa12 through Qam1 and Qam2 respectively whose source electrodes are commonly connected to the drain electrode of a MOS transistor QE and the drain electrodes of which are connected to a pair of the bit lines BL1 and $\overline{BL1}$ through BLm and $\overline{BLm}$ and to a pair of the bus lines BS and $\overline{BS}$ through one of MOS transistors Q11 and Q12 through Qm1 and Qm2. The transistor pairs Q11 and Q12 through Qm1 and Qm2 are operated by the column decoders CDEC1 through CDECm respectively.

When read-out of information from, for example, the memory cell MC11 is effected, the transistors QR11 through QR2m which have been previously turned on by a reset signal RST and electric charges of the capacitors CD11 through CD2m of the dummy cells DC11 through DC2m are discharged. The row line WL1 is selected by the row decoder RDEC and the potential of the row line WL1 becomes high. At the same time, the dummy row line DWL2 is selected and the potential of the dummy row line DWL2 becomes high. Therefore, the transistor QC11 of the memory cell MC11, and the transistor QD21 of the dummy cell DC21 are both turned on, and, the capacitor C11 and the capacitor CD21 are respectively connected to the bit lines BL1 and $\overline{BL1}$ through the transistors QC11 and QD21. Since the bit lines BL1 and $\overline{BL1}$ are both, as is well known, precharged, for example, to a high potential and the capacitance of each of the memory cells MCjk is larger than that of each of the dummy cells CD1k and CD2k, the potential of the bit line BL1 becomes lower than that of the bit line $\overline{BL1}$ if the capacitor C11 is not charged, i.e. if the information "0" is stored in the memory cell MC11.

Then, a clock signal LE becomes high and the transistor QE is turned on so that the sense amplifiers SA1 through SAm are enabled. Since the potential of the gate electrode of the transistor Qa12, i.e., the potential of the bit line BL1 is lower than that of the gate electrode of the transistor Qa11, i.e., that of the bit line $\overline{BL1}$ as mentioned above, the transistor Qa12 is turned off and the transistor Qa11 is turned on, so that the potential of the bit line BL1 becomes much lower and the potential of the bit line $\overline{BL1}$ becomes much higher.

In this condition, the transistors Q11 and Q12 are both turned on by the column decoder CDEC1 and the bit lines BL1 and $\overline{BL1}$ are respectively connected to the bus lines BS and $\overline{BS}$. Therefore, the potentials of the bit lines BL1 and $\overline{BL1}$ are respectively transferred to the bus lines BS and BS. The input/output amplifier AMP detects the potential difference between the bus lines BS and $\overline{BS}$ and outputs a read out data Dout corresponding to the potential difference.

It should be noted that the smaller the stray capacitance of each of the bit lines BL1 and $\overline{BL1}$ becomes as compared with the capacitance of each of the capacitors C11 and CD21, the larger the potential difference between the bit lines BL1 and $\overline{BL1}$ becomes, so that the sense amplifier SA1 can easily and surely detect the potential difference. However, according to the increase in the integration degree of the memory device, the size of each of the memory cells is decreased and the number of memory cells connected to a bit line is increased, so that the stray capacitance of each of the bit lines becomes larger and the capacitance of the capacitor of each of the memory cells becomes smaller. Therefore, when the memory capacity of the memory device becomes very large, the potential difference between the bit lines connected to the same sense amplifier is decreased to a value near the lower limit of the differential input voltage of the sense amplifier so that it is very difficult to detect the potential difference.

Generally, in a 16 Kbit memory device having the memory cells of 128×128 bit, the number of sense amplifiers is 128, the number of memory cells connected to a bit line is 64 and thus one of 128 memory cells disposed in a column and one of the dummy cells are connected to one sense amplifier. In the 64 Kbit memory device having memory cells of 256×256 bit, the number of the sense amplifiers is 256 and the number of the memory cells connected to a bit line is 128. Therefore, in the 64 Kbit memory device, the number of memory cells connected to a bit line is twice that of the 16 Kbit memory device and the length of each of the bit lines becomes longer, so that the stray capacitance of each bit line becomes large and the potential difference between the bit lines becomes small. As a result, it is necessary to use sense amplifiers having extreme precision.

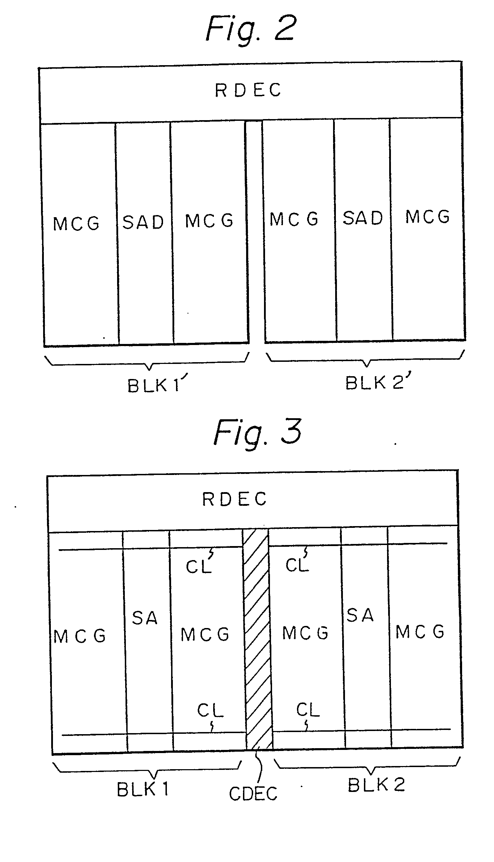

In order to solve the above-mentioned problem, an arrangement of circuit components on the semiconductor chip of the memory device illustrated in Fig. 2 can be used. In the arrangement of Fig. 2, two memory blocks BLK1′ and BLK2′ each of which consists of a sense amplifier and column decoder group SAD and two memory cell groups MCG disposed on both sides of the sense amplifier and column decoder group SAD are used. The row decoder RDEC selects one row from either memory blocks BLK1′ or BLK2′. The column decoders in the sense amplifier and column decoder groups SAD of both memory blocks operate at the same time and select the same columns of the memory blocks BLK1′ and BLK2′. In the arrangement of Fig. 2, when the memory capacity is 64 Kbit, each of the memory cell groups MCG has 64 rows and 256 columns and the number of the memory cells connected to a bit line is 64. Therefore, the potential difference between the bit lines can be the same as that of the 16 Kbit memory device, and it is not necessary to use sense amplifiers having extreme precision. In the memory device having a still larger memory capacity, for example, 256 Kbit or 512 Kbit, the number of the memory blocks is increased, so that the number of the memory cells connected to a bit line does not increase greatly. In this case, the sense amplifiers and the column decoders are both disposed in the central portion of each memory block.

However, in the above-mentioned arrangement, the area on the semiconductor chip of the memory device occupied by the sense amplifier and column decoder groups is relatively large, so that the area on which the memory cells are formed becomes small and thus the area on the semiconductor chip cannot be used effectively. For example, in the 64 Kbit memory device having the arrangement of Fig. 2, the width of each of the memory cell groups MCG on the semiconductor chip is approximately 500 through 600 µm and the width of each of the same amplifier and column decoder groups SAD is approximately 350

through 400 µm. Therefore, the width of each one of the memory blocks BLK1′ and BLK2′ is approximately 1350 through 1600 µm and each of the sense amplifier and column decoder groups SAD occupies approximately 25% of the area of each of the memory blocks BLK1′ and BLK2′. On the semiconductor chip of the memory device, it is also necessary to form other circuit components such as the row decoder RDEC, and thus the area on which the memory cells are formed becomes smaller.

Moreover, in the above-mentioned arrangement, the number of the column decoders driven by each of column address buffers (not shown in the drawing) is large and, therefore, the load capacitance of each of the column address buffers is large, so that the operating speed of each of the column address buffers is decreased.

As illustrated in Figure 3, in an embodiment of the present invention, a common column decoder CDEC is disposed between the memory blocks BLK1 and BLK2, and each of the memory blocks BLK1 and BLK2 comprises a sense amplifier group SA and two memory cell groups MCG disposed on both sides of the sense amplifier group SA. From both sides of the common column decoder CDEC, a plurality of column lines CL extend, in a transverse direction of Figure 3, to both of the memory blocks BLK1 and BLK2. A row decoder DDEC disposed at the upper sides of the memory blocks BLK1 and BLK2 in Figure 3 selects a row from the memory cell groups MCG of both memory blocks BLK1 and BLK2. It should be noted that in the embodiment of Figure 3, in which the column decoder CDEC is provided commonly to the memory blocks BLK1 and BLK2, the common column decoder CDEC can be disposed not only in the central portion of the semiconductor chip between the memory blocks BLK1 and BLK2 but also in an outer side of each of the memory blocks BLK1 and BLK2.

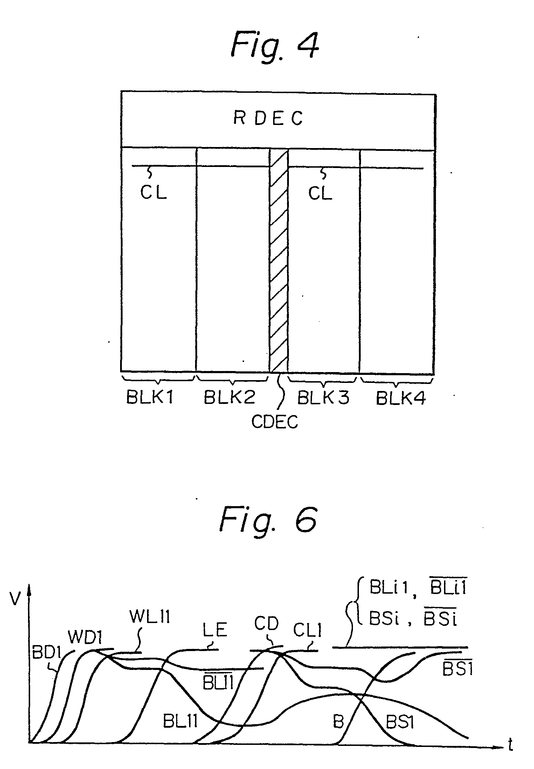

Fig. 4 illustrates another embodiment of the present invention. In the embodiment of Fig. 4, four memory blocks BLK1 through BLK4 are used and a common column decoder CDEC is disposed in the central portion between two memory blocks BLK1, BLK2 and two memory blocks BLK3, BLK4. Each of the memory blocks BLK1 through BLK4 comprises a sense amplifier group and two memory cell groups disposed on both sides of the sense amplifier. From both sides of the common column decoder CDEC, a plurality of column lines CL extend to the memory blocks BLK1 and BLK2 and to the memory blocks BLK3 and BLK4. A row decoder RDEC is disposed at the upper sides of the memory blocks BLK1 through BLK4 and selects a row from the memory blocks BLK1 through BLK4. As mentioned above, it is possible to disposed the common column decoder CDEC also on the outer side of each of the memory blocks BLK1 and BLK4 or in the intermediate portion between the memory blocks BLK1 and BLK2 or between the memory blocks BLK3 and BLK4.

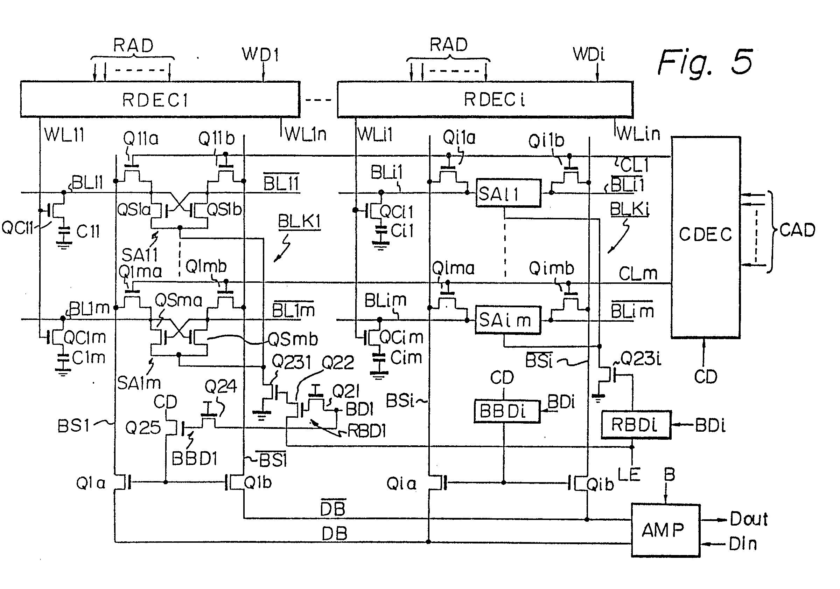

Fig. 5 illustrates a circuit of a part of a memory device as a still another embodiment of the present invention. The memory device of Fig. 5 comprises i memory blocks BLK1 through BLKi, a common column decoder CDEC which is common to the memory blocks BLK1 through BLKi, and, i row decoders RDEC1 through RDECi each of which corresponds to one of the memory blocks BLK1 through BLKi. Each of the memory blocks BLK1 through BLKi comprises a sense amplifier group consisting of m sense amplifiers SA11, . . . , SA1m through SAi1, . . . , SAim and two memory cell groups each of which consists of a plurality of memory cells and dummy cells and is disposed on both sides of the sense amplifier group. Each of the memory cells or the dummy cells consists of a capacitor and a MOS transistor such as a capacitor C11 and a MOS transistor QC11. In Fig. 5, only a part of the memory cells of the memory cell groups is illustrated and the illustration of the other memory cells and the dummy cells is omitted. From the row decoders RDEC1 through RDECi, n row lines or word lines WL11, . . . , WL1n through WLi1, . . . , WLin respectively extend, in a longitudinal direction of Fig. 5, to the corresponding memory blocks BLK1 through BLKi, and m memory cells are connected to each of the row lines WL11, . . . , WL1n through WLi1, . . . , WLin. From each of the sense amplifiers SA11, . . . , SA1m through SAi1, . . . , SAim, one of the bit line pairs BL11 and $\overline{BL11}$, . . . , BL1m and $\overline{BL1m}$ through BLi1 and $\overline{BLi1}$, . . . , BLim and $\overline{BLim}$ extends in a transverse direction in Fig. 5 and each of the bit lines is connected to n/2 memory cells and a dummy cell (not shown in the drawing) in a corresponding column. On both sides of the sense amplifier groups, pairs of bus lines BS1 and $\overline{BS1}$ through BSi and $\overline{BSi}$ are respectively disposed and the pairs of these bus lines are commonly connected to a pair of data buses DB and $\overline{DB}$ through pairs of transistors Q1a and Q1b through Qia and Qib, respectively. These pairs of transistors Q1a and Q1b through Qia and Qib are respectively turned on and off by block bus line decoders BBD1 through BBDi which are operated by block selecting address signals BD1 through BDi respectively. The pair of data buses DB and $\overline{DB}$ are connected to an input/output amplifier AMP which is controlled by a clock signal B. A pair of input/output terminals of each of the sense amplifiers, for example, SA11 through SA1m are connected to the pair of bus lines BS1 and $\overline{BS1}$ through each pair of transistors Q11a and Q11b through Q1ma and Q1mb, respectively. The input/output terminals of the sense amplifiers in the other rows are also connected to the bus line pairs in the same rows. From the common column decoder CDEC, m column lines CL1 through CLm extend in a transversal direction in Fig. 5 and are connected to pairs of the transistors Q11a and Q11b, . . . , Qi1a and Qi1b through Q1ma and Q1mb, . . . , Qima and Qimb of the corresponding columns respectively. Each of the sense amplifiers comprises a pair of cross coupled MOS transistors. For example, the sense amplifiers SA11 through SA1m comprise pairs of cross coupled MOS transistors QS1a and QS1b through QSma and QSmb, respectively. The source electrodes of these cross coupled transistors of the sense amplifiers in the same row, for example, SA11 through SA1m are commonly connected to the ground through the MOS transistor Q231 which is operated by row block decoder RBD1 of the same row. Each of the row block decoders RBD1 through RBDi comprises two MOS transistors. For example the row block decoder RBD1 comprises MOS transistors Q22 and Q21. Each of the block bus line decoders BBD1 through BBDi comprises two MOS transistors such as Q24 and Q25 of the block bus line decoder BBD1.

In Fig. 5, each of the block selecting address signals BD1 through BDi is produced from, for example, one or more upper bits of row address information and becomes high only when a corresponding memory block is selected. For example, when the memory block BLK1 is selected, the block selecting address signal BD1 becomes high and all the other block selecting address signals BD2 through BDi are low. WD1 through WDi designate gated clock signals which are produced by gating a row address clock signal WD (not shown in the drawing) by using the block selecting address signals BD1 through BDi. Therefore, only one of the gated clock signals WD1 through WDi of the selected memory block becomes high. Each of the row decoders RDEC1 through RDECi receives row address signals RAD and one of the gated clock signals WD1 through WDi, and the potential of only one of the row lines WL11, . . . , WL1n through WLi1, . . . , WLin of the selected memory blocks, whose gated clock signal is high, becomes high. CD designates a column line clock signal, LE designates an enable clock signal for the sense amplifiers and B designates a clock signal for the input/output amplifier AMP.

The read out operation of the memory device of Fig. 5 will now be described. For example, when the memory cell consisting of the transistor QC11 and the capactior C11 is selected, the gated clock signal WD1 and the row address signals RAD are added to the row decoder RDEC1. The row decoder RDEC1 decodes the row address signals RAD and makes the potential of the row line WL11 high, so that the transistors QC11 through QC1m of the memory cells connected to the row line WL11 are turned on and the capacitors C11 through C1m are respectively connected to the bit lines BL11 through BL1m. At the same time with the potential change of the row line WL11 to high level, the potential of the dummy row line (not shown in the drawing) connected to the row decoder RDEC1 is changed to high level and the transistors of the dummy cells connected to the dummy row line are turned on.

Then, the block selecting address signal BD1 and the enable clock signal LE are both turned to high and the transistor Q22 is turned on through the transistor Q21, so that the transistor Q231 is turned on and the sense amplifiers SA11 through SA1m are activated. The potential difference between the bit lines BL11 and $\overline{BL11}$ is detected and amplified by the sense amplifier SA11 and the potential difference between the bit lines BL11 and $\overline{BL11}$ is enlarged. At the time the potential difference between the bit lines BL11 and $\overline{BL11}$ is well enlarged, the column decoder CDEC decodes the column address signals CAd under the control of the column line clock signal CD and turns the potential of the column line CL1 to high, so that the transistors Q11a and Q11b are both turned on. Since the column line clock signal CD and the block selecting address signals BD1 are both high, the transistor Q25 of the block bus line decoder BBD1 is turned on through the transistor Q24 and the transistors Q1a and Q1b are both turned on. Therefore, the bit lines BL1 and $\overline{BL1}$ are respectively connected to the bus lines BS1 and $\overline{BS1}$ through the transistors Q11a and Q11b, and connected to the data buses DB and $\overline{DB}$ through the transistors Q1a and Q1b. The input/output amplifiers AMP which is operated by the clock signal B detects and amplifies the potential difference between the data buses DB and $\overline{DB}$ and outputs the read out signal Dout.

When the above-mentioned read out operation is effected, operation of non-selected memory blocks, for example, BLKi is effected as follows. When the column line CL1 is selected and the potential thereof has changed from low to high, the potential of the block selecting address BDi applied to the row block decoder RBDi is low and the transistor Q23i is in the turned off condition, so that the sense amplifiers SAi1 through SAim are not enabled. Therefore, the potential of the bit lines BLi1 and $\overline{BLi1}$ is maintained in a high level and the potential of the bus lines BSi and $\overline{BSi}$ is in a high level, so that the transistors Qi1a and Qi1b are in the turned off condition. This is because, even if the high level voltage is applied to the gate electrodes of the transistors Qi1a and Qi1b, the potential of the source, drain and gate electrodes of each of the transistors Qi1a and Qi1b are approximately the same and thus the transistors Qi1a and Qi1b do not turn on. In this condition, the potential of each of the row lines WLi1 through WLin is low, because the gated clock signal WDi applied to the row decoder RDECi is in a low potential level. Therefore, none of the transistors of the memory cells of the non-selected memory block, for example, BLKi is turned on, so that the information stored in the memory cells of the non-selected memory blocks is not destroyed.

Since the block selecting address signal, for example, BDi of the non-selected memory block is in a low potential level and the potential of the output signal of the block bus line decoder BBDi is low, the transistors Qia and Qib are both in a turned off condition. Therefore, the bus lines BSi and $\overline{BSi}$ of the non-selected memory block are not connected to the data buses DB and $\overline{DB}$, but only the bus lines BS1 and $\overline{BS1}$ of the selected memory block are connected to the data buses DB and $\overline{DB}$ whose potential difference is detected by the input/output amplifier AMP at the time designated by the clock signal B.

Fig. 6 illustrates waveforms of the signals on the points of the circuit of Fig. 5. As illustrated in Fig. 6, after the potential of the row line, for example, WL11 of the row decoder RDEC1 has changed from low to high due to the potential change of the block selecting address signal BD1 and the gated clock signal WD1 from low to high, the potential difference appears between the bit lines BL11 and $\overline{BL11}$ according to the information stored in the memory cell comprising the capacitor C11. If the capacitor C11 is charged, i.e., information "1" is stored, the potential of the bit line BL11 is slightly higher than that of the bit line $\overline{BL11}$, and if the capacitor C11 is not charged, i.e., information "0" is stored, the potential of the bit line BL11 is slightly lower than that of the bit line $\overline{BL11}$. Fig. 6 illustrates the case that the capacitor C11 is not charged. Then, the enable clock signal LE changes from low to high and the potential difference between the bit lines BL11 and $\overline{BL11}$ is enlarged by the sense amplifier SA11. Since the potential of the bit line BL11 is slightly lower than that of the bit line $\overline{BL11}$, the transistor QS1a of the sense amplifer SA11 is turned on and the transistor QS1b of the sense amplifier SA11 is turned off, so that the potential of the bit line BL11 falls greatly.

Then, after the column line clock signal CD changes from low to high, the potential of the column line, for example, CL1 connected to the column decoder CDEC changes from low to high and the bit lines BL11 and $\overline{BL11}$ are connected to the bus lines BS1 and $\overline{BS1}$, respectively. Therefore, the potential of the bus line $\overline{BS1}$ slightly falls to the same potential as that of the bit line $\overline{BL11}$. On the other hand, the potential of the bus line BS1 falls and the potential of the bit line BL11 rises, so that the potentials of the bus line BS1 and the bit line BL11 reach approximately the same level.

In this condition, the clock signal B applied to the input/output amplifier AMP changes from low to high and the input/output amplifier AMP is enabled, thereby the potential of the bus line BS1 falling to the lower level and the potential of the bus line $\overline{BS1}$ rising to the higher level after a slight fall down. The waveforms of the potentials of the data buses DB and $\overline{DB}$ are approximately the same as those of the potentials of the bus lines BS1 and $\overline{BS1}$, respectively, and therefore the illustration thereof is omitted. The input/output amplifier AMP outputs the read out signal Dout in accordance with the potential difference between the data buses DB and $\overline{DB}$. In this case, the potential of the bit lines such as BLi1 and $\overline{BLi1}$ of each of the non-selected memory blocks and the potential of the bus lines such as BSi and $\overline{BSi}$ of each of the non-selected memory blocks are both in a high level as illustrated in Fig. 6.

As mentioned above, in the memory device according to the present invention, since the column decoder CDEC is common to a plurality of memory blocks, the area of the semiconductor chip can be smaller than that of the conventional memory device comprising a sense amplifier and column decoder group for every memory block. Although the column lines CL1 through CLm are connected commonly from the column decoder CDEC to each memory block, the information stored in the memory cells of the non-selected memory blocks are not destroyed. This is because, only the sense amplifiers of the selected memory block are enabled by the block selecting address signal and the sense amplifiers and the row lines of the non-selected memory blocks are not enabled. Moreover, since the sense amplifiers of the non-selected memory blocks are not enabled, the power consumption of the memory device can be decreased and the load of the enable clock signal LE can be reduced.

Therefore, according to the present invention, it is possible to provide a MOS dynamic type RAM device having a high integration degree and a low power consumption, and according to the present invention, it is easy to provide a RAM device having a memory capacity of 64 Kbit or more.

## Claims

1. A semiconductor memory device comprising a number of memory blocks (BLK) each of which includes a sense amplifier array (SA) consisting of a number of sense amplifiers and a pair of dynamic type memory cell groups (MCG); a number of row decoders (RDEC1, ..., RDECi) each of which is associated with its corresponding memory block and each of which receives row address signals (RAD) and gated clock signals (WD1, ..., WD$_i$) for its corresponding memory blocks, the gated clock signals being produced by gating a row address clock signal with block selecting address signals (BD), each of the row decoders (RDEC1, ..., RDECi) selecting a particular row line (WL) in the memory blocks (BLK) in response to the gated clock signal; a column decoder (CDEC), a pair of data bus lines (DB, $\overline{DB}$) and an input/output amplifier (AMP) which are common to all the memory blocks (BLK), the column decoder (CDEC) selectively connecting pairs of input/output terminals of one sense amplifier (SA) from each of the memory blocks (BLK) to pairs of bus lines (BS1, $\overline{BS1}$, ..., BSi, $\overline{BSi}$) associated with the memory blocks (BLK) by changing the potential of one of a number of column lines (CL) connected between the column decoder (CDEC) and the memory blocks (BLK), the pair of data bus lines (DB, $\overline{DB}$) being connected to the input/output amplifier (AMP); row block decoders (RBD) which selectively enable the sense amplifier array (SA) of one of the memory blocks (BLK) in accordance with the block selecting address signals; gate transistors (Q1a, Q1b, ..., Qia, Qib) connected between the pairs of bus lines (BS1, $\overline{BS1}$, ..., BSi, $\overline{BSi}$) and the data bus lines (DB, $\overline{DB}$); and, block bus line decoders (BBD1, ..., BBDi) which control the operation of the gate transistors (Q1a, Q1b,

..., Qia, Qib) to selectively connect the pairs of bus lines (BS1, $\overline{BS1}$, ..., BSi, $\overline{BSi}$) associated with each of the memory blocks (BLK) to the pair of data bus lines (DB, $\overline{DB}$) in accordance with the block selecting address signals.

2. A semiconductor memory device according to claim 1, in which the column decoder (CDEC) is located along an outer edge of one of the memory blocks.

3. A semiconductor memory device according to claim 1 or 2, in which the column decoder (CDEC) is located between a pair of memory blocks.

4. A semiconductor memory device according to any one of the preceding claims, in which the column decoder (CDEC) is located centrally between the number of memory blocks.

5. A semiconductor memory device according to any one of the preceding claims, in which the block selecting address signals (BD) are produced from a part of the row address information.

6. A semiconductor memory device according to any one of the preceding claims, in which the pair of memory cell groups (MCG) in each of the memory blocks (BLK) is arranged on both sides of the sense amplifier array (SA) of that memory block (BLK).

7. A semiconductor memory device according to any one of the preceding claims, in which each of the dynamic type memory cells comprises a MOS transistor (QC) and a capacitor (C).

## Revendications

1. Dispositif de mémoire à semiconducteurs comprenant un certain nombre de blocs de mémoire (BLK) qui comportent chacun un réseau (SA) d'amplificateurs de lecture constitué d'un certain nombre d'amplificateurs de lecture et une paire de groups (MCG) de cellules de mémoire du type dynamique; un certain nombre de décodeurs de rangée (RDEC1, ..., RDECi) qui sont chacun associés à un block de mémoire correspondant et qui reçoivent chacun des signaux d'adresse de rangée (RAD) et des signaux d'horloge déclenchés (WD1, ..., WDi) pour leurs blocs de mémoire correspondants, les signaux d'horloge déclenchés étant produits par déclenchement d'un signal d'adresse de rangée à l'aide de signaux d'adresse de sélection de bloc (BD), chacun des décodeurs de rangée (RDEC1, ..., RDECi) sélectionnant une ligne de rangée particulière (WL) dans les blocs de mémoire (BLK) en réponse au signal d'horloge déclenché; un décodeur de colonne (CDEC), une paire de lignes de bus de donnée (DB, $\overline{DB}$) et un amplificateur d'entrée-sortie (AMP) qui sont communs à tous les blocs de mémoire (BLK), le décodeur de colonne (CDEC) connectant sélectivement des pairs de bornes d'entrée-sortie d'un amplificateur de lecture (SA) de chacun des blocs de mémoire (BLK) à des paires de lignes de bus (BS1, $\overline{BS1}$, ..., BSi, $\overline{BSi}$) associées aux blocs de mémoire (BLK) par modification du potentiel de l'une parmi un certain nombre de lignes de colonne (CL) connectées entre le décodeur de colonne (CDEC) et les blocs de mémoire (BLK) la paire de lignes de bus de donnée (DB, $\overline{DB}$) étant connectée à l'amplificateur d'entrée-sortie (AMP); des décodeurs de bloc de rangée (RBD) qui valident sélectivement le réseau (SA) d'amplificateurs de lecture de l'un des blocs de mémoire (BLK) en fonction des signaux d'adresse de sélection de bloc; des transistors servant de portes (Q1a, Q1b, ...., Qia, Qib) connectés entre les paires de lignes de bus (BS1, $\overline{BS1}$), ..., BSi, $\overline{BSi}$) et les lignes de bus de donnée (DB, $\overline{DB}$); et des décodeurs de ligne de bus de bloc (BBD1, ..., BBDi) qui commandent le fonctionnement des transistors servant de portes (Q1a, Q1b, ..., Qia, Qib) afin de connecter sélectivement les paires de lignes de bus (BSi, $\overline{BS1}$, ..., Bsi, $\overline{BSi}$) associées à chacun des blocs de mémoire (BLK) avec la paire de lignes de bus de donnée (DB, $\overline{DB}$) en fonction des signaux d'adresse de sélection de bloc.

2. Dispositif de mémoire à semiconducteur selon la revendication 1, dans lequel le décodeur de colonne (CDEC) est placé le long d'un bord extérieur de l'un des blocs de mémoire.

3. Dispositif de mémoire à semiconducteurs selon la revendication 1 ou 2, dans lequel le décodeur de colonne (CDEC) est placé entre deux blocs de mémoire.

4. Dispositif de mémoire à semiconducteurs selon l'une quelconque des revendications précédentes, dans lequel le décodeur (CDEC) est placé centralement entre les divers blocs de mémoire.

5. Dispositif de mémoire à semiconducteurs selon l'une quelconque des revendications précédentes, dans lequel les signaux d'adresse de sélection de bloc (BD) sont produits à partir d'une partie de l'information d'adresse de rangée.

6. Dispositif de mémoire à semiconducteurs selon l'une quelconque des revendications précédentes, dans lequel la paire de groupes (MCG) de cellules de mémoire de chacun des blocs de mémoire (BLK) est placée de part et d'autre du réseau (SA) d'amplificateurs de lecture de ce bloc de mémoire (BLK).

7. Dispositif de mémoire à semiconducteurs selon l'une quelconque des revendications précédentes, dans lequel chacune des cellules de mémoire du type dynamique comprend un transistor MOS (QC) et un condensateur (C).

**Patentansprüche**

1. Halbleiterspeicheranordnung mit einer Anzahl von Speicherblöcken (BLK), von denen jeder ein Leseverstärkerarray (SA) umfaßt, welches aus einer Anzahl von Leseverstärkern und einem Paar von dynamischen Speicherzellengruppen (MCG) besteht;

einer Anzahl von Reihendecodern (RDEC1, ..., RDECi), von denen jeder seinem entsprechenden Speicherblock zugeordnet ist und Reihenadressensignale (RAD) und torgesteuerte Taktsignale (WD1, ..., WDi) für seine entsprechenden Speicherblöcke empfängt, wobei die torgesteuerten Taktsignale durch Torsteuerung eines Reihenadressentaktsignals mit Blockauswahladressensignalen (BD) erzeugt werden, und jeder der Reihendecoder (RDEC1, ..., RDECi) eine besondere Reihenleitung (WL) in den Speicherblöcken (BLK) in Abhängigkeit von dem torgesteuerten Taktsignal auswählt;

einem Spaltendecoder (CDEC), einem Paar von Datenbusleitungen (DB, $\overline{DB}$) und einen Eingangs/Ausgangs-Verstärker (AMP), welche allen Speicherblöcken (BLK) gemeinsam sind, wobei der Spaltendecoder (CDEC) durch Veränderung des Potentials einer der Anzahl von Spaltenleitungen (CL), die zwischen dem Spaltendecoder (CDEC) und den Speicherblöcken (BLK) angeschlossen sind, selektiv Paare von Eingangs/Ausgangs-Anschlüssen eines Leseverstärkers (SA) von jedem der Speicherblöcke (BLK) mit Paaren von Busleitungen (BS1, $\overline{BS1}$, ..., BSi, $\overline{BSi}$) verbindet, welche den Speicherblöcken (BLK) zugeordnet sind, wobei die Paare von Datenbusleitungen (DB, $\overline{DB}$) mit den Eingangs/Ausgangs-Verstärker (AMP) verbunden sind;

Reihenblockdecodern (RBD), welche selektiv das Leseverstärkerarray (SA) eines der Speicherblöcke (BLK) in Übereinstimmung mit dem Blockauswahladressensignalen eingeschalten;

Gatetransistoren (Q1a, Q1b, ..., Qia, Qib), die zwischen den Paaren von Busleitungen (BS1, $\overline{BS1}$, ..., BSi, $\overline{BSi}$) und den Datenbusleitungen (DB, $\overline{DB}$) angeschlossen sind, und

Blockbusleitungsdecodern (BBD1, ..., BBDi), die den Betrieb der Gatetransistoren (Q1a, Q1b, ..., Qia, Qib) steuern, um wahlweise die Paare von Busleitungen (BS1, $\overline{BS1}$, ..., BSi, $\overline{BSi}$), die jedem der Speicherblöcke (BLK) zugeordnet sind, mit dem Paar von Datenbusleitungen (DB, $\overline{DB}$) in Übereinstimmung mit den Blockauswahladressensignalen zu verbinden.

2. Halbleiterspeicheranordnung nach Anspruch 1, bei welcher der Spaltendecoder (CDEC) längs einem äußeren Rand von einem der Speicherblöcke angeordnet ist.

3. Halbleiterspeicheranordnung nach Anspruch 1 oder 2, bei welcher der Spaltendecoder (CDEC) zwischen einem Paar von Speicherblöcken angeordnet ist.

4. Halbleiterspeicheranordnung nach einem der vorhergehenden Ansprüche, bei welcher der Spaltendecoder (CDEC) zentral zwischen der Anzahl von Speicherblöcken angeordnet ist.

5. Halbleiterspeicheranordnung nach einem der vorhergehenden Ansprüche, bei welchem die Blockauswahladressensignale (BD) aus einem Teil der Reihenadresseninformation erzeugt werden.

6. Halbleiterspeicheranordnung nach einem der vorhergehenden Ansprüche, bei welcher die Paare von Speicherzellengruppen (MCG) in jedem der Speicherblöcke (BLK) auf beiden Seiten des Leseverstärkerarrays (SA) von diesem Speicherblock (BLK) angeordnet sind.

7. Halbleiterspeicheranordnung nach einem der vorhergehenden Ansprüche, bei welcher jede der dynamischen Speicherzellen einen MOS-Transistor (QC) und einen Kondensator (C) umfaßt.

Fig. 1

0 037 233

## Fig. 2

| RDEC | | | | | |
|------|-----|-----|-----|-----|-----|
| MCG | SAD | MCG | MCG | SAD | MCG |

BLK1′　　　　　　　BLK2′

## Fig. 3

| RDEC | | | | | | |
|------|-----|-----|-----|-----|-----|-----|
| MCG | SA | CL′<br><br>MCG<br><br>CL | | CL′<br><br>MCG<br><br>CL | SA | MCG |

BLK1　　　CDEC　　　BLK2

## Fig. 4

## Fig. 6

Fig. 5

0 037 233